# EUROPEAN PATENT APPLICATION

(11) **EP 4 376 157 A1**
(43) Date of publication of application: **29.05.2024**
(21) Application number: 23194382.0
(22) Date of filing: 30.08.2023
(51) Int. Cl.: H01M 10/42, H01M 50/105, H01M 50/178, H01M 50/55, H01M 50/557

(54) **RECHARGEABLE BATTERY PACK**

(30) Priority: 23.11.2022 KR 20220158665
(71) Applicant: Samsung SDI Co., Ltd., Yongin-si, Gyeonggi-do 17084 (KR)
(72) Inventor: CHO, Hyun, 17084 Yongin-si (KR); LEE, Woojin, 17084 Yongin-si (KR)
(74) Representative: Marks & Clerk LLP

(57) **Abstract**

An embodiment of the present disclosure has been made in an effort to provide a rechargeable battery pack capable of implementing nonflammablility for a connection portion between a printed circuit board and a flexible printed circuit board in a protection circuit module. The rechargeable battery pack includes a battery cell configured to draw out an electrode tab from an electrode assembly accommodated in a pouch, a protection circuit module (PCM) connected to an electrode tab drawn out to a terrace of the pouch and connected to a printed circuit board (PCB) including a protection circuit through a flexible printed circuit board (FPCB), a top tape configured to surround the protection circuit module and is attached to the battery cell to form a terrace space therein, and a flame retardant coated portion formed by coating a flame retardant coating agent on at least one portion of the protection circuit module exposed to an outside of the top tape.

## Description

### BACKGROUND OF THE INVENTION

### (a) Field of the Invention

The present disclosure relates to a rechargeable battery pack, and more particularly, to a rechargeable battery pack that implements nonflammablility for a connection portion between a printed circuit board and a flexible printed circuit board in a protection circuit module.

### (b) Description of the Related Art

A rechargeable battery can be repeatedly charged and discharged, unlike a primary battery. A low-capacity rechargeable battery is used for small portable electronic devices such as a mobile phone, a notebook computer, and a camcorder, and a large-capacity rechargeable battery is used as a power supply for driving a motor such as for a hybrid car.

For example, a rechargeable battery includes an electrode assembly for charging and discharging, a case accommodating the electrode assembly and an electrolyte solution, a cap plate coupled to an opening of the case, and an electrode terminal that is electrically connected to the electrode assembly to draw out the electrode assembly to the outside of the cap plate.

A rechargeable battery pack is formed by providing a protection circuit module (PCM) to an electrode terminal of the rechargeable battery. A connection portion between a printed circuit board (PCB) and a flexible printed circuit board (FPCB) in the protection circuit module (PCM) of the rechargeable battery pack is drawn out through a cut portion of a top tape. Accordingly, the connection portion between the printed circuit board and the flexible printed circuit board is exposed without being covered by the top tape.

Since a customer requires nonflammablility for the exposed connection portion, a flame retardant tape is used to cover the connection portion. As for a flame retardant tape, when the flexible printed circuit board is drawn out from a side, it is possible to secure nonflammablility with a smooth finish.

However, when the flexible printed circuit board is drawn out from a front, an exposed portion inevitably occurs in the middle of the protection circuit module due to the structure of a pouch pack, so there is bending on the flexible printed circuit board, and the flame retardant tape becomes unable to finish covering the exposed portion. That is, when it is drawn out from the front, the flame retardant tape becomes unable to secure complete nonflammablility for the exposed portion.

The above information disclosed in this Background section is only for enhancement of understanding of the background of the invention, and therefore, it may contain information that does not form the prior art that is already known to a person of ordinary skill in the art.

### SUMMARY OF THE INVENTION

An embodiment of the present disclosure has been made in an effort to provide a rechargeable battery pack implementing nonflammablility for a connection portion between a printed circuit board and a flexible printed circuit board in a protection circuit module.

An embodiment of the present disclosure has been made in an effort to provide a rechargeable battery pack ensuring nonflammablility at a connection portion by covering the connection portion even when a flexible printed circuit board (FPCB) is drawn out from the printed circuit board (PCB) of the protection circuit module (PCM) to the front or side.

An embodiment of the present invention provides a rechargeable battery pack including: a battery cell configured to draw out an electrode tab from an electrode assembly accommodated in a pouch; a protection circuit module (PCM) connected to an electrode tab drawn out to a terrace of the pouch and connected to a printed circuit board (PCB) including a protection circuit through a flexible printed circuit board (FPCB); a top tape configured to surround the protection circuit module and that is attached to the battery cell to form a terrace space therein; and a flame retardant coated portion formed by coating a flame retardant coating agent on at least one portion of the protection circuit module exposed to an outside of the top tape.

The top tape may be attached to a first surface of the pouch forming the terrace and is firstly bent, may cover the terrace space to which the protection circuit module is attached and is secondly bent, and may be attached to a second surface of the pouch.

The rechargeable battery pack may further include a protection tape provided between the terrace and the protection circuit module, the terrace may include a first side surface of the pouch accommodating an electrode assembly and a first bottom connected to the first side surface, and the protection tape may include a second side surface and a second bottom connected to the second side surface to be attached to correspond to the first side surface and the first bottom surface.

The electrode tab may be drawn out and bent to an end of the first bottom of the terrace to be positioned on the second bottom of the protection tape attached to the first bottom of the terrace space.

The electrode tab may be drawn out and bent to an end of the first bottom of the terrace to be positioned on the first bottom of the terrace space, and the printed circuit board may be connected to the electrode tab via a connection tab.

The top tape may form an opening corresponding to a connection portion between the printed circuit board and the flexible printed circuit board, and the flame retardant coated portion may be formed by coating a flame retardant coating on the connection portion positioned in the opening.

The flexible printed circuit board may include a connector connected to a load, and a bending portion between the printed circuit board and the connector.

The flexible printed circuit board may be connected in a width direction of the printed circuit board at a predetermined position between opposite ends of the printed circuit board in a longitudinal direction.

The flame retardant coated portion may cover an end portion of the flexible printed circuit board positioned on the printed circuit board, and a soldering part connecting the printed circuit board and the flexible printed circuit board.

The soldering part may be provided in a plurality along a length direction of the printed circuit board, and the flame retardant coated portion may be formed long (e.g. lengthways) in a longitudinal direction to perform flame retardant coating on a plurality of soldering parts.

The flame retardant coated portion may further perform flame retardant coating on opposite ends of the printed circuit board at opposite ends in the longitudinal direction.

The flame retardant coated portion may perform flame retardant coating on upper and lower surfaces of the printed circuit board at opposite ends in the longitudinal direction.

The flame retardant coating portion may have a thickness of 20 µm to 110 µm.

A depth of the bending portion may be set to a size that is smaller than or equal to a distance between the printed circuit board and an outer surface of the first bottom.

The bending portion may be formed to have a U-shape or V-shape.

The flexible printed circuit board may be connected in a longitudinal direction of the printed circuit board at one side of opposite ends of the printed circuit board in the longitudinal direction.

The flame retardant coated portion may cover an end portion of the flexible printed circuit board positioned on the printed circuit board, and a soldering part connecting the printed circuit board and the flexible printed circuit board.

The flame retardant coated portion may further perform flame retardant coating on upper and lower surfaces of the printed circuit board at opposite ends in the longitudinal direction.

At least some of the above and other features of the invention are set out in the claims.

As such, according to an embodiment of the present disclosure, the flame retardant coated portion may be provided on a portion exposed to an outside of the top tape in the protection circuit module, and thus nonflammablility for the exposed portion may be implemented. That is, in an embodiment of the present disclosure, it is possible to implement nonflammablility for the connection portion between the printed circuit board and the flexible printed circuit board in the protection circuit module.

According to an embodiment of the present disclosure, a connection portion is provided with a flame retardant coating, and thus it is possible to obtain complete nonflammablility at the connection portion even when a flexible printed circuit board (FPCB) is drawn out from the printed circuit board (PCB) of the protection circuit module (PCM) to a front or side.

### BRIEF DESCRIPTION OF THE DRAWINGS

FIG. 1 illustrates an exploded perspective view of a rechargeable battery pack according to a first embodiment of the present disclosure.
FIG. 2 illustrates an exploded perspective view of a protection circuit module (PCM) of FIG. 1, in which a flexible printed circuit board (FPCB) is drawn out from a printed circuit board (PCB) to a front.
FIG. 3 illustrates a cross-sectional view of the protection circuit module (PCM) of FIG. 1 taken along a line III-III after being coupled.
FIG. 4 illustrates a perspective view from above showing a protection circuit module (PCM) in a rechargeable battery pack according to a second embodiment of the present disclosure, in which a flexible printed circuit board (FPCB) is drawn out from a printed circuit board (PCB) to a side.
FIG. 5 illustrates a perspective view of FIG. 4 seen from below.

### DETAILED DESCRIPTION OF THE EMBODIMENTS

Hereinafter, the present invention will be described more fully with reference to the accompanying drawings, in which embodiments of the invention are shown. As those skilled in the art would realize, the described embodiments may be modified in various different ways, all without departing from the scope of the present invention. The drawings and description are to be regarded as illustrative in nature and not restrictive. Like reference numerals designate like elements throughout the specification.

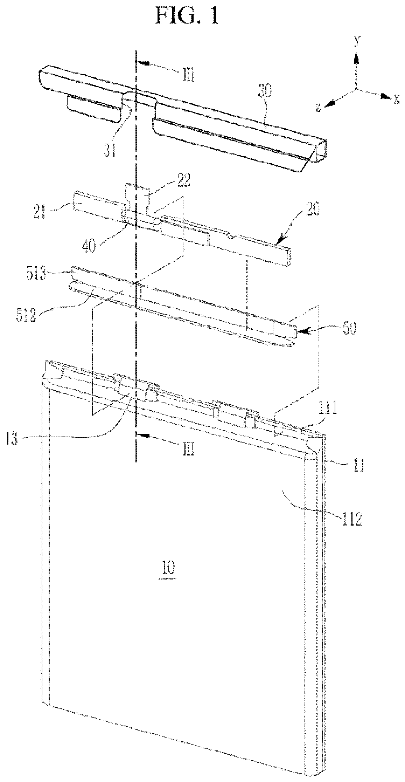

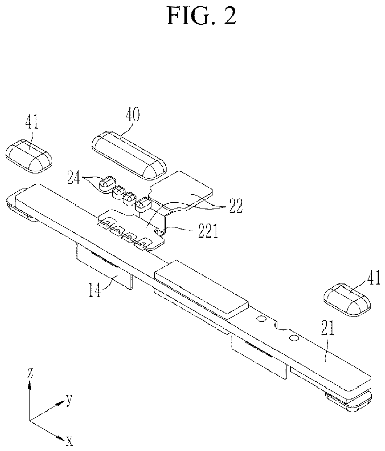

FIG. 1 illustrates an exploded perspective view of a rechargeable battery pack according to a first embodiment of the present disclosure, and FIG. 2 illustrates an exploded perspective view of a protection circuit module (PCM) of FIG. 1, in which a flexible printed circuit board (FPCB) is drawn out from a printed circuit board (PCB) to a front.

Referring to FIG. 1 and FIG. 2, the rechargeable battery pack of the first embodiment includes a battery cell 10, a protection circuit module (PCM) 20, a top tape 30, and a flame retardant coated portion 40.

Although described as a protection circuit module (PCM) in the present embodiment, a protection module package (PMP) having a resin mold on a printed circuit board (PCB) is also included.

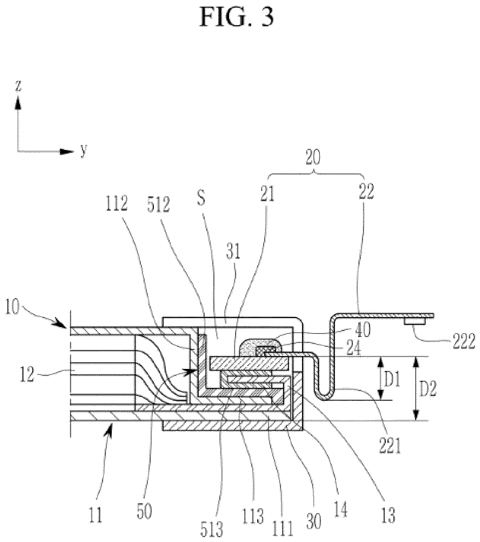

FIG. 3 illustrates a cross-sectional view of the protection circuit module (PCM) of FIG. 1 taken along a line III-III after being coupled. Referring to FIG. 1 to FIG. 3, the battery cell 10 is configured by drawing out an electrode tab 13 from an electrode assembly 12 accommodated in a pouch 11. In other words, the battery cell 10 comprises a pouch 11, an electrode assembly 12 accommodated in the pouch 11, and an electrode tab 13 that is drawn out from the electrode assembly 12.

The electrode assembly 12 includes a first electrode (e.g., a negative electrode) and a second electrode (e.g., a positive electrode) provided at opposite sides of a separator that is an electrical insulating material, and is formed by winding the negative electrode, the separator, and the positive electrode. In addition, the electrode assembly may be formed to have a stacked structure (not illustrated).

The negative electrode and the positive electrode each include an electrode substrate of a metal foil (e.g., Cu, Al foil), that is, a coated portion in which an active material is applied to a current collector, and a plurality of non-coated region tabs formed of a current collector exposed by not applying an active material.

The uncoated region tabs are stacked and connected to the electrode tab 13 to allow a current to be charged and discharged to and from the electrode assembly 12 to flow. Accordingly, the electrode assembly 12 may charge and discharge a high current through the electrode tab 13.

The protection circuit module 20 is connected to the electrode tab 13 drawn out to a terrace 111 of the pouch 11 via a connection tab 14 (a nickel tab as an example). The protection circuit module 20 includes a printed circuit board (PCB) 21 having a protection circuit and a flexible printed circuit board (FPCB) 22 connected thereto. The flexible printed circuit board (FPCB) 22 connects the protection circuit module 20 to a load.

The top tape 30 surrounds the protection circuit module 20 to be attached to the battery cell 10 to form a space S of the terrace 111 therein. As an example, the top tape 30 is attached to a first surface of the pouch 11 forming the terrace 111 and is firstly bent, covering the space S of the terrace 111 to which the protection circuit module 20 is attached and is secondly bent, and is attached to a second surface of the pouch 11.

The top tape 30 exposes a portion of the protection circuit module 20. That is, a portion of the protection circuit module 20 is exposed to the outside of the top tape 30. The flame retardant coated portion 40 is formed by coating a flame retardant coating agent on at least one of externally exposed portions of the top tape 30. In other words, the flame retardant coated portion 40 is on at least one portion of the protection circuit module exposed to an outside of the top tape 30.

The rechargeable battery pack of the first embodiment further includes a protection tape 50. The protection tape 50 is provided between the terrace 111 and the protection circuit module 20. That is, the terrace 111 includes a first side surface 112 of the pouch 11 accommodating the electrode assembly 12 and a first bottom 113 connected to the first side surface 112.

Accordingly, the protection tape 50 includes a second side surface 512 and a second bottom 513 bent and connected to the second side surface 512. The second side surface 512 and the second bottom 513 are attached to correspond to the first side surface 112 and the first bottom 113, respectively.

The electrode tab 13 is drawn out to an end of the first bottom 113 of the terrace 111 and bent to be positioned on the second bottom 513 of the protection tape 50 attached to the first bottom 113 of the space S of the terrace 111.

More specifically, the electrode tab 13 is disposed between upper and lower sides of the connection tab 14, which is bent since the connection tab 14 is bent when it is welded to the connection tab 14. Accordingly, the connection tab 14 and the electrode tab 13 are stacked between the printed circuit board 21 and the second bottom 513 of the protective tape 50. In this case, the connection tab 14 and the electrode tab 13 electrically and mechanically firmly maintain connection therebetween.

Referring to FIG. 1 and FIG. 3, the top tape 30 forms an opening 31 corresponding to a connection portion between the printed circuit board 21 and the flexible printed circuit board 22. That is, the opening 31 enables draw-out of the flexible printed circuit board 22 connected to the printed circuit board 21.

The flame retardant coated portion 40 is formed by coating a flame retardant coating agent on a connection portion positioned in the opening 31. The flexible printed circuit board 22 is connected to the printed circuit board 21 by a soldering part 24. The flame retardant coated portion 40 covers the soldering part 24 and an end portion of the flexible printed circuit board 22 disposed on the printed circuit board 21.

As an example, the soldering part 24 is provided in a plurality along a length direction (x-axis direction) of the printed circuit board 21 to connect the flexible printed circuit board 22 to the printed circuit board 21 at a plurality of points. The flame retardant coated portion 40 is formed long (e.g. lengthways) in a longitudinal direction (x-axis direction) to perform flame retardant coating to the plurality of soldering parts 24.

A flame retardant coated portion 41 further performs the flame retardant coating on opposite ends of the printed circuit board 21 at opposite ends in the longitudinal direction (x-axis direction). As an example, the flame retardant coated portion 41 integrally performs the flame retardant coating on upper and lower surfaces of the printed circuit board 21 at the opposite ends in the longitudinal direction (x-axis direction).

As an example, the flame retardant coated portions 40 and 41 may have a thickness of 20 µm to 110 µm. When the thickness is smaller than 20 µm, it may be difficult to obtain the required flame retardant performance, and when the thickness exceeds 110 µm, a flame retardant may be excessively used compared to improvement of the flame retardant performance.

Referring back to FIG. 1 to FIG. 3, the flexible printed circuit board 22 connects the printed circuit board 21 to a load (not illustrated), has a bending portion 221 therebetween, and absorbs a change in length and shock or vibration between the printed circuit board 21 and the load to block transmission of impact or vibration from the load to the printed circuit board 21.

As an example, the bending portion 221 may be formed to have a U-shape or V-shape. A depth D1 of the bending portion 221 is set to a size equal to or smaller than a distance D2 between the printed circuit board 21 and an outer surface of the terrace 111. The distance D2 may even include a thickness of an outer surface of the top tape 30.

Specifically, the flexible printed circuit board 22 includes a connector 222 connected to the load. The bending portion 221 is provided between the printed circuit board 21 and the connector 222 to prevent transfer of vibration and impact from the connector 222 to the printed circuit board 21.

The flexible printed circuit board 22 is connected in a width direction (y-axis direction) of the printed circuit board 21 at a predetermined position between opposite ends of the printed circuit board 21 in a longitudinal direction (x-axis direction). That is, the flexible printed circuit board 22 is drawn out to a front of the printed circuit board 21 or the battery cell 10.

A second embodiment of the present disclosure will be described below. For convenience, compared to the first embodiment, a description of the same components will be omitted and different components will be described.

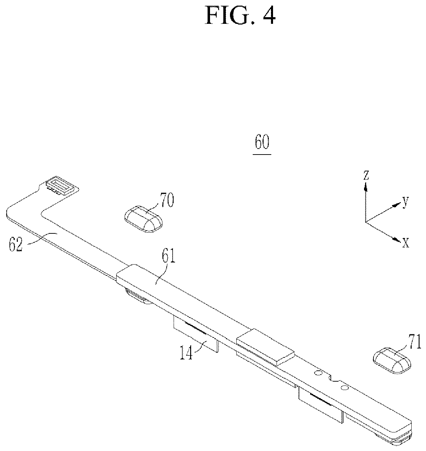

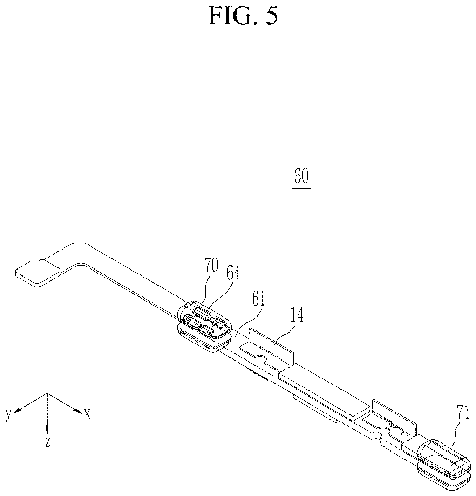

FIG. 4 illustrates a perspective view from above showing a protection circuit module (PCM) in a rechargeable battery pack according to a second embodiment of the present disclosure, in which a flexible printed circuit board (FPCB) is drawn out from a printed circuit board (PCB) to a side, and FIG. 5 illustrates a perspective view of FIG. 4 seen from below.

Referring to FIG. 4 and FIG. 5, in the protection circuit module 60, the flexible printed circuit board 62 is connected in the longitudinal direction (x-axis direction) of the printed circuit board 61 at one side of opposite ends of the printed circuit board 61 in the longitudinal direction (x-axis direction).

The flame retardant coated portion 70 covers an end portion of the flexible printed circuit board 62 positioned on the printed circuit board 61, and a soldering part 64 connecting the printed circuit board 61 and the flexible printed circuit board 62. That is, the flame retardant coated portion 70 integrally performs the flame retardant coating on upper and lower surfaces of the printed circuit board 61 at a first end in the longitudinal direction (x-axis direction).

Opposite ends of the flame retardant coated portion 71 are flame retardant coated at a second end in the longitudinal direction (x-axis direction). As an example, the flame retardant coated portion 71 integrally performs the flame retardant coating on upper and lower surfaces of the printed circuit board 61 at a first end in the longitudinal direction (x-axis direction).

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

### <Description of Symbols>

| | | | |
|---|---|---|---|
| 10: | battery cell | 11: | pouch |
| 12: | electrode assembly | 13: | electrode tab |
| 14: | connection tab | | |
| 20: | protection circuit module (PCM) (PCB) | 21: | printed circuit board |
| 22: | flexible printed circuit board (FPCB) | 24: | soldering part |
| 30: | top tape | 31: | opening |
| 40, 41: | flame retardant coated portion | 50: | protection tape |
| 60: | protection circuit module | 61: | printed circuit board |
| 62: | flexible printed circuit board | 64: | soldering part |
| 70, 71: | flame retardant coated portion | 111: | terrace |
| 112: | first side | 113: | first bottom |
| 221: | bending portion | 222: | connector |
| 512: | second side | 513: | second bottom |
| D1: | depth | D2: | distance |
| S: | space | | |

## Claims

1. A rechargeable battery pack comprising:
a battery cell configured to draw out an electrode tab from an electrode assembly accommodated in a pouch;
a protection circuit module connected to an electrode tab drawn out to a terrace of the pouch and connected to a printed circuit board including a protection circuit through a flexible printed circuit board;
a top tape configured to surround the protection circuit module and attached to the battery cell to form a terrace space therein; and
a flame retardant coated portion formed by coating a flame retardant coating agent on at least one portion of the protection circuit module exposed to an outside of the top tape.

2. The rechargeable battery pack of claim 1, wherein
the top tape:
is attached to a first surface of the pouch forming the terrace and is firstly bent;
covers the terrace space to which the protection circuit module is attached and is secondly bent; and
is attached to a second surface of the pouch.

3. The rechargeable battery pack of claim 1 or claim 2, further comprising
a protection tape provided between the terrace and the protection circuit module,
wherein the terrace includes a first side surface of the pouch accommodating an electrode assembly and a first bottom connected to the first side surface, and
the protection tape includes a second side surface and a second bottom connected to the second side surface to be attached to correspond to the first side surface and the first bottom surface.

4. The rechargeable battery pack of claim 3, wherein
the electrode tab is drawn out and bent to an end of the first bottom of the terrace to be positioned on the second bottom of the protection tape attached to the first bottom of the terrace space.

5. The rechargeable battery pack of claim 1 or claim 2, wherein
the electrode tab is drawn out and bent to an end of the first bottom of the terrace to be positioned on the first bottom of the terrace space, and
the printed circuit board is connected to the electrode tab via a connection tab.

6. The rechargeable battery pack of claim 5, wherein
the top tape forms an opening corresponding to a connection portion between the printed circuit board and the flexible printed circuit board, and
the flame retardant coated portion is formed by coating a flame retardant coating on the connection portion positioned in the opening.

7. The rechargeable battery pack of claim 6, wherein
the flexible printed circuit board includes a connector connected to a load, and
a bending portion between the printed circuit board and the connector.

8. The rechargeable battery pack of claim 6 or claim 7, wherein the flexible printed circuit board is connected in a width direction of the printed circuit board at a predetermined position between opposite ends of the printed circuit board in a longitudinal direction.

9. The rechargeable battery pack of any one of claims 6 to 8, wherein the flame retardant coated portion covers an end portion of the flexible printed circuit board positioned on the printed circuit board, and a soldering part connecting the printed circuit board and the flexible printed circuit board.

10. The rechargeable battery pack of claim 9, wherein
the soldering part is provided in a plurality along a length direction of the printed circuit board, and
the flame retardant coated portion is formed long in a longitudinal direction to perform flame retardant coating on a plurality of soldering parts.

11. The rechargeable battery pack of claim 9 or claim 10, wherein
the flame retardant coated portion further performs flame retardant coating on opposite ends of the printed circuit board at opposite ends in the longitudinal direction, optionally wherein:
the flame retardant coated portion further performs flame retardant coating on upper and lower surfaces of the printed circuit board at opposite ends in the longitudinal direction.

12. The rechargeable battery pack of any one of claims 4 to 11, wherein
the flame retardant coating portion has a thickness of 20 µm to 110 µm.

13. The rechargeable battery pack of any one of claims 7 to 12, wherein
a depth of the bending portion is set to a size that is smaller than or equal to a distance between the printed circuit board and an outer surface of the first bottom, optionally wherein:
the bending portion is formed to have a U-shape or V-shape.

14. The rechargeable battery pack of claim 5, wherein
the flexible printed circuit board is connected in a longitudinal direction of the printed circuit board at one side of opposite ends of the printed circuit board in the longitudinal direction.

15. The rechargeable battery pack of claim 14, wherein
the flame retardant coated portion covers an end portion of the flexible printed circuit board positioned on the printed circuit board, and a soldering part connecting the printed circuit board and the flexible printed circuit board, optionally wherein:
the flame retardant coated portion further performs flame retardant coating on upper and lower surfaces of the printed circuit board at opposite ends in the longitudinal direction.
